# EUROPEAN PATENT APPLICATION

(11) **EP 1 271 158 A2**
(43) Date of publication of application: **02.01.2003**
(21) Application number: 02254318.5
(22) Date of filing: 20.06.2002
(51) Int. Cl.: G01R 1/067

(54) **Press contact structure of probe unit**

(30) Priority: 22.06.2001 JP 2001189850
(71) Applicant: Soshotech Co., Ltd., Ebina-shi, Kanagawa-ken (JP)
(72) Inventor: Okuno, Toshio, Yokohama-shi, Kanagawa-ken (JP); Kunimasu, Toshio, Kawasaki-shi, Kanagawa-ken (JP)
(74) Representative: Rees, Alexander Ellison

(57) **Abstract**

The present invention provides a probe unit in which satisfactory resilient shifting action of a lead portion supporting a conductive bump and a supplementary pressure imparting resilient body is realized, and a wiping action is taken place between the conductive bump and an external contact, thereby soundly press-contacting the conductive bump with respect to the external contact. A press-contact structure of a probe unit comprises an insulative film 1 with a plurality of leads 2 arranged in array on a surface thereof, a press-contact conductive bump 3 formed on one end of each lead 2, and a cantilever inclination end portion 7 formed by pushing up one end of each lead 2 and one end of the insulative film 1, where one end of the lead 2 is disposed, by a supplementary pressure imparting resilient body 4, the conductive bump 3 being backed up on the cantilever inclination end portion 7 with the supplementary pressure imparting resilient body 4, the cantilever inclination end portion 7 being shifted in a direction for reducing the inclination angle while compressing the supplementary pressure imparting resilient body 4, when the conductive bump 4 is press-contacted with an external contact of an electronic part, a press-contacting force of the conductive bump 3 with respect to the external contact being obtained by a restoring force of the supplementary pressure imparting resilient body 4.

## Description

### BACKGROUND OF THE INVENTION

### Field of the Invention

This invention relates to a probe unit used for inspecting, among other purposes, a circuit board with a given electronic part mounted thereon, such as an IC package, an IC wafer, a liquid crystal panel, a plasma display or the like.

### Related Art

As shown in Japanese Patent Application Laid-Open No. H09-178777, discloses, as shown in FIG. 1, a probe unit wherein a plurality of leads 2 are arranged in parallel on a surface of an insulative film 1, one end of each lead 2 is provided with a conductive bump 3, which is for the use of press-contact, one end of each lead and one end of the insulative film 1 where one end of each lead 2 is disposed, is backed up by a supplementary pressure imparting resilient body 4 formed of a circular columnar body, the supplementary pressure imparting resilient body 4 is compressed when the conductive bump 3 is press-contacted with an external contact of an electronic part, and a press-contacting force of the conductive bump 3 with respect to the external contact is obtained by the restoring force of the supplementary pressure imparting resilient body 4.

In this related art, one end of the insulative film 4 and one end of the lead 2 are bonded for restraint to a base 5 on opposite left and right sides of the circular columnar body for forming the supplementary pressure imparting resilient body 4 through an adhesive material 6 and at the same time, the film 1 and the lead 2 are adhered to an arcuate surface of the circular columnar body in such a manner as to copy the contour of the arcuate surface between the left and right restraining portions. In that condition, the conductive bump 3 is disposed on this arcuate surface.

However, in the related art, since the insulative film 4 and the lead 2 are restrained on the opposite left and right sides of the circular columnar body forming the supplementary pressure imparting resilient body 4, the lead portion supporting the conductive bump 3 is difficult to deform resiliently and the circular columnar body for backing up the conductive bump 3 is also difficult to deform resiliently. Thus, it gives rise to such a problem that the conductive bump 3 is difficult to be soundly contacted with the external contact of the electronic part.

### SUMMARY OF THE INVENTION

It is, therefore, an object of the present invention to provide a probe unit in which satisfactory resilient shifting action of a lead portion supporting a conductive bump and a supplementary pressure imparting resilient body is realized, and a wiping action is taken place between the conductive bump and an external contact, thereby soundly press-contacting the conductive bump with respect to the external contact.

In this probe unit, a cantilever inclination end portion is formed by pushing up one end of each lead and one end of the insulative film, where one end of the lead is disposed, by a supplementary pressure imparting resilient body.

A contact surface of the cantilever inclination end portion with respect to the supplementary pressure imparting resilient body is a free contact surface and a terminal end of the cantilever inclination end portion defines a free end.

The conductive bump is backed up on the cantilever inclination end portion with the supplementary pressure imparting resilient body, the cantilever inclination end portion is shifted in a direction for reducing the inclination angle while compressing the supplementary pressure imparting resilient body, when the conductive bump is press-contacted with an external contact of an electronic part, and a press-contacting force of the conductive bump with respect to the external contact is obtained by a restoring force of the supplementary pressure imparting resilient body.

The conductive bump conducts a wiping action with respect to a surface of the external contact in a shifting process of the cantilever inclination end portion.

The supplementary pressure imparting resilient body is formed, for example, of a circular columnar body, and one end of the lead and one end of the insulative film are pushed up on a general line of the circular columnar body to form the cantilever inclination end portion.

The circular columnar body forming the supplementary pressure imparting resilient body is fitted into a V-shaped groove so as to be supported on a pair of inclination surfaces defining the V-shaped groove, and one side portion of the circular columnar body is projected from the V-shaped groove to achieve the pushing-up action.

According to the present invention, when the conductive bump is press-contacted with the external contact of the electronic part, resilient shifting of the cantilever inclination end portion and compression of the supplementary pressure imparting resilient body can be achieved in a satisfactory manner and a sound press-contact can be obtained.

Moreover, the conductive bump conducts a wiping action with respect to the surface of the external contact in the resiliently shifting process of the cantilever inclination end portion, and thus, reliability of the press-contact is enhanced.

### BRIEF DESCRIPTION OF THE DRAWINGS

FIG. 1 is a sectional view showing, on an enlarged scale, a press-contact structure of a conventional probe unit;
FIG. 2 is a sectional view showing, on an enlarged scale, a press-contact structure of a probe unit according to the present invention, in which a circular columnar body is used as a supplementary pressure imparting resilient body;
FIG. 3 is a sectional view showing, on an enlarged scale, a press-contact structure of a probe unit according to the present invention, in which a square columnar body is used as a supplementary pressure imparting resilient body;
FIG. 4 is a sectional view showing, on an enlarged scale, a press-contact structure of a probe unit according to the present invention, in which an arcuate columnar body is used as a supplementary pressure imparting resilient body;
FIG. 5 is a sectional view showing, on an enlarged scale, another example of the conductive bump in the press-contact structure in the probe unit;
FIG. 6 is a plan view showing, on an enlarged scale, a press-contact structure in the probe unit; and
FIG. 7 is a sectional view showing a contacting action of the press-contact structure in the probe unit.

### DETAILED DESCRIPTION OF THE INVENTION

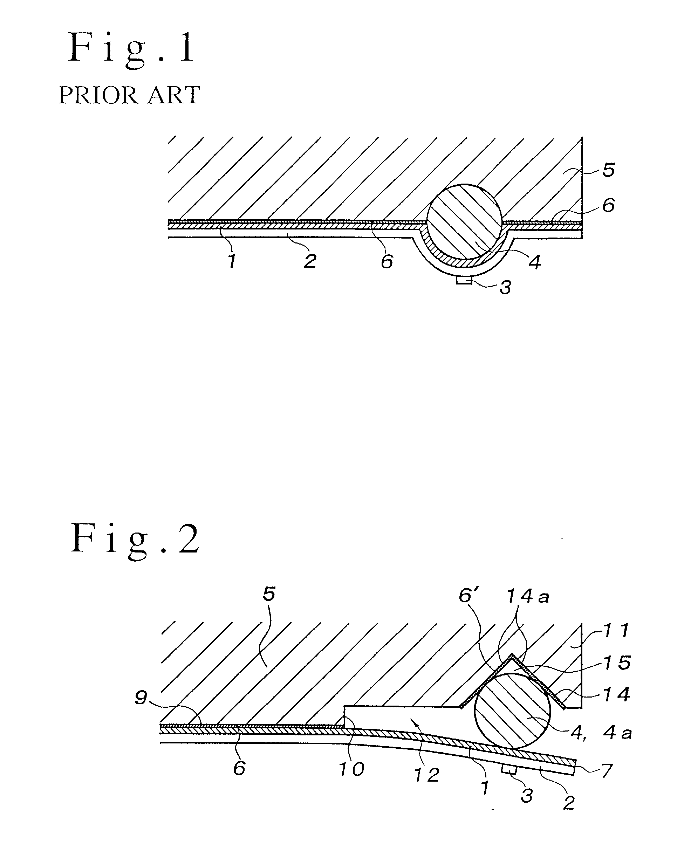

As shown in FIGS. 2 through 6, a plurality of leads are adhered to a surface of a square insulative film 1 which is composed of a synthetic resin. The leads 2 are arranged in array at fine pitches on the insulative film 1 such that each lead 2 extend from one side of the insulative film 2 to the other side. Each lead 2 has a press-contact conductive bump 3 formed on one end thereof.

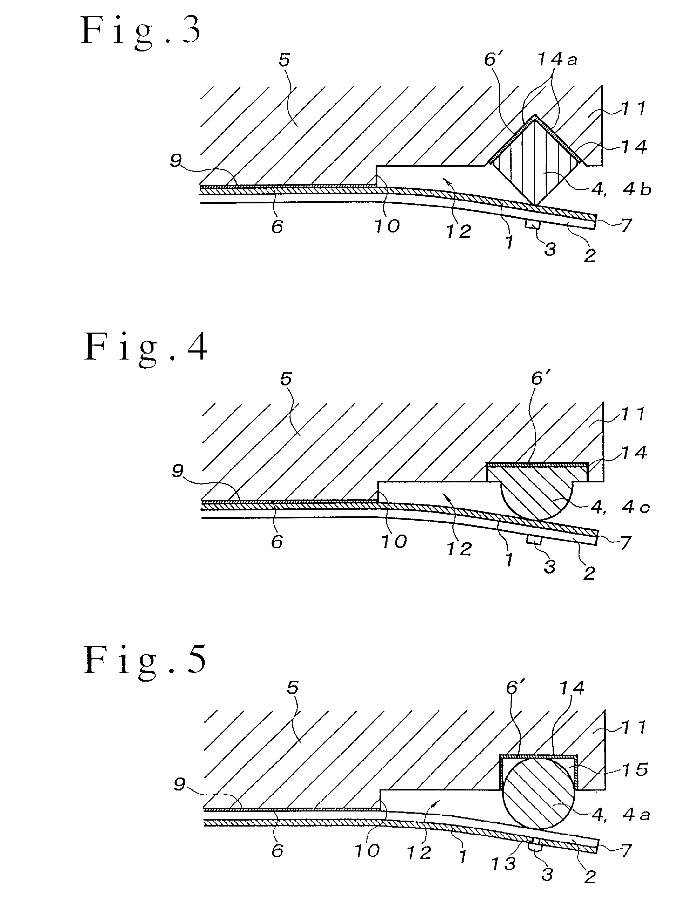

As shown in FIG. 2, the conductive bump 3 is integral with the lead 2 and projected from a surface of the lead 2 on the opposite side of an adhesion surface between the insulative film 1 and the lead 2. Also, as shown in FIG. 5, a conductive bump 3 integral with the lead 2 is projected from an adhesion surface of the lead 2 with respect to the insulative film 1 such that the conductive bump 5 extends through a through hole 13 formed in the insulative film 1 and projects from the surface on the other side of the insulative film 1 with respect to the adhesion surface.

An adhesion body formed by adhering the insulative film 1 and the lead 2 together is adhered to a surface of a base 5 through an adhesive material 6. In the probe unit shown in FIG. 2, the insulative film 1 is adhered to the surface of the base 5 at its surface on the other side of the surface where the lead 2 is laid. In the probe unit shown in FIG. 5, the insulative film 1 is adhered to the surface of the base 5 at its surface on the side where the lead 2 is laid.

One end of the insulative film 1 and one end of the lead 2 are expanded by a predetermined length dimension from its adhesion surface 9 with respect to the base 5. The expanded end portion, that is, one end of the lead 2 and one end of the insulative film 1 where one end of the lead 2 is disposed, is pushed up by a supplementary pressure imparting resilient body 4 to form a cantilever inclination portion 7. The conductive bump 3 is backed up with the supplementary pressure imparting resilient body 4, which is formed of rubber or vinyl chloride, on the cantilever inclination end portion 7.

The supplementary pressure imparting resilient body 4 is supported on the base 5. That is, one end of the base 5 is expanded from one end of the adhesion surface 9 through a step 10, and the supplementary pressure imparting resilient body 4 is supported on the expanded end portion 11 of the base 5.

The cantilever inclination end portion 7 is expanded via the step 10, and a space 12 corresponding to the step 10 is formed between one end of the adhesion surface 9 and the supplementary pressure imparting resilient body 4.

The expanded end portion 11 and the cantilever inclination end portion 7 are spacedly extended in parallel relation, and one end of the insulative film 1 and the lead 2 are pushed up with the supplementary pressure imparting resilient body 4 in the space formed between the expanded end portion 11 and the cantilever inclination end portion 7, thereby forming the cantilever inclination end portion 7.

A contact surface of the cantilever inclination end portion 7 with respect to the supplementary pressure imparting resilient body 4 is a free contact surface. A terminal end of the cantilever inclination end portion 7 is defined as a free end.

The supplementary pressure imparting resilient body 4 is formed of a columnar body. Preferably, the body 4 is, as shown in FIG. 2, formed of a circular columnar body 4a, and one end of the lead 2 and one end of the insulative film 1 are pushed up on a general line of the circular columnar body 4a to form the cantilever inclination end portion 7.

The circular columnar body 4a forming the supplementary pressure imparting resilient body 4 is fitted into a groove 14 formed in a confronting surface of the expanded end portion 11 with respect to the insulative film 1. Preferably, the body 4 is, as shown in FIG. 2, fitted into a V-shaped groove and supported on a pair of inclination surfaces 14a which forms the V-shaped groove 14. And one side portion of the circular columnar body 4a is projected from the V-shaped groove 14 so as to be used for the above-mentioned pushing-up operation.

The circular columnar body 4a is attached to the pair of inclination surfaces 14a of the V-shaped groove 14 on the opposing general lines within the V-shaped groove 14, through, for example, a double sided adhesive tape 6'. A space 15 is formed at a bottom portion of the V-shaped groove 14 so as to allow a base material to escape into the space 15 at the time of compression of the circular columnar body 4a.

A contact surface of the cantilever inclination end portion 7 with respect to the circular columnar body 4a is a free contact surface, a terminal end of the cantilever inclination end portion 7 is defined as a free end which is expanded from the contact surface with respect to the circular columnar body 4a.

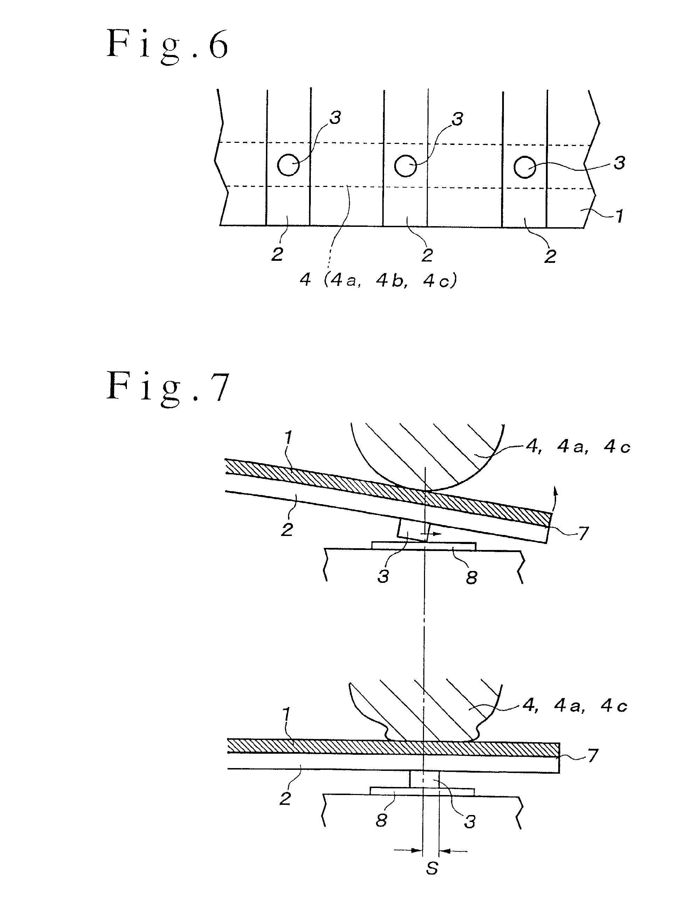

As shown in FIG. 7, when the conductive bump 3 is press-contacted with a surface of an external contact 8 of an electronic part such as an IC package, an IC wafer, a liquid crystal panel, a plasma display or the like, and an electronic part-mounted substrate, the cantilever inclination end portion 7 is resiliently shifted in a direction for reducing its angle of inclination while compressing the circular columnar body 4a and a press-contacting force of the conductive bump 3 with respect to the external contact 8 is obtained by restoring force of the circular columnar body 4a. The cantilever inclination end portion 7 is resiliently shifted about the step 10 of the end portion of the adhesion surface 9, or about the nearby area of the adhesion surface 9, i.e., nearby area of the step 10. That is, the cantilever inclination end portion 7 has a supporting point for its shifting motion at a location from the end portion of the adhesion surface 9 to the supplementary pressure imparting resilient body 4.

The conductive bump 3 conducts a wiping action with respect to the surface of the external contact 8 in the shifting process of the cantilever inclination end portion 7. That is, the conductive bump 3 is slidingly moved on the surface of the external contact 8, thereby removing an oxide film formed on the contact surface. As a result, a sound contact can be achieved at an active metal surface. Reference character S in the Figure denotes an amount of sliding movement of the conductive bump 3 with respect to the external contact 8.

As another example of the supplementary pressure imparting resilient body, the supplementary pressure imparting resilient body 4 is, as shown in FIG. 3, formed of a prismatic columnar body 4b, preferably of a square columnar body, and the prismatic columnar body 4b is fitted into the groove 14 formed in the confronting surface of the expanded end portion 11 with respect to the insulative film 1.

Preferably, the prismatic columnar body 4b is, as shown in FIG. 3, is fitted into the V-shaped groove 14 and an adjacent pair of side surfaces of the prismatic columnar body 4b is supported by a pair of inclination surfaces 14a forming the V-shaped groove 14. And an angular portion forming the other adjacent pair of inclination surfaces of the prismatic columnar body 4b is projected from the V-shaped groove 14 so as to be used for the pushing-up operation. That is, the cantilever inclination end portion 7 is supported by the angular portion of the prismatic columnar body 14b. The prismatic columnar body 4b is attached at its pair of side surfaces to the pair of inclination surfaces 14a of the V-shaped groove 14 through an adhesive material such as, for example, a double sided adhesive tape 6'.

The contact surface of the cantilever inclination end portion 7 with respect to the angular portion of the prismatic columnar body 4b is a free end contact surface, and a terminal end of the cantilever inclination end portion 7 is defined as an expanded free end which is expanded from its contact surface with respect to the prismatic columnar body 4b.

As in the case where the circular columnar body 4a shown in FIG. 7 is used, when the conductive bump 3 is press-contacted with the surface of the external contact 8 of the electronic part, the cantilever inclination end portion 7 is resiliently shifted in a direction for reducing its angle of inclination while compressing the angular portion of the prismatic columnar body 6b, and a press-contacting force of the conductive bump 3 with respect to the external contact 8 is obtained by the restoring force of the prismatic columnar body 4b.

Moreover, the conductive bump 3 conducts a wiping action with respect to the surface of the external contact 8 in the shifting process of the cantilever inclination end portion 7. That is, the conductive bump 3 is slidingly moved on the surface of the external contact 8 and removes an oxide film formed on the surface of the external contact 8. As a result, a sound contact can be obtained with respect to the active metal surface.

As another example of the supplementary pressure imparting resilient body 4, the supplementary pressure imparting resilient body 4 is, as shown in FIG. 4, formed of an arcuate columnar body 4c, and one end of the lead 2 and one end of the insulative film 1 are pushed up on the general line of the arcuate columnar body 4c, thereby forming the cantilever inclination end portion 7.

The arcuate columnar body 4c forming the supplementary pressure imparting resilient body 4 is fitted into the groove 14 forming in the confronting surface of the expanded end portion 11 with respect to the insulative film 1 and supported thereon. One side portion of the arcuate columnar body 4c is projected from the groove portion 14 so as to be used for the pushing-up operation. The arcuate columnar body 4c is fitted at its seat portion into the groove 14 and attached thereto through an adhesive material such as, for example, a double sided adhesive tape 6'.

The contact surface of the cantilever inclination end portion 7 with respect to the arcuate columnar body 4c is a free contact surface, and a terminal end of the cantilever inclination end portion 7 is defined as a free end which is expanded from its contact surface with respect to the arcuate columnar body 4c.

As shown in FIG. 7, when the conductive bump 3 is press-contacted with the surface of the external contact 8 of the electronic part, the cantilever inclination end portion 7 is resiliently shifted in a direction for reducing the angle of inclination while compressing the arcuate columnar body 4c, and a press-contacting force of the conductive bump 3 with respect to the external contact 8 is obtained by the restoring force of the arcuate columnar body 4c.

Moreover, the conductive bump 3 conducts a wiping action with respect to the surface of the external contact 8 in the shifting process of the cantilever inclination end portion 7. That is, the conductive bump 3 is slidingly moved on the surface of the external contact 8 and removes an oxide film formed on the surface of the external contact 8. As a result, a sound contact can be obtained with respect to the active metal surface.

The supplementary pressure imparting resilient body 4, i.e., the circular columnar body 4a, the prismatic columnar body 4b or the arcuate columnar body 4c, extends in such manner as to transverse one ends of the leads 2 which are arranged in array, and a plurality of conductive bumps 3 are arranged at fine pitches on a columnar body. Accordingly, the groove 14 also extends in such a manner as to transverse one ends of the leads 2 which are arranged in array.

## Claims

1. A press-contact structure of a probe unit comprising an insulative film with a plurality of leads arranged in array on a surface thereof, a press-contact conductive bump formed on one end of each lead, and a cantilever inclination end portion formed by pushing up one end of each lead and one end of said insulative film, where one end of said lead is disposed, by a supplementary pressure imparting resilient body, said conductive bump being backed up on said cantilever inclination end portion with said supplementary pressure imparting resilient body, said cantilever inclination end portion being shifted in a direction for reducing the inclination angle while compressing said supplementary pressure imparting resilient body when said conductive bump is press-contacted with an external contact of an electronic part, a press-contacting force of said conductive bump with respect to said external contact being obtained by a restoring force of said supplementary pressure imparting resilient body.

2. A press-contact structure of a probe unit according to claim 1, wherein said conductive bump conducts a wiping action with respect to a surface of said external contact in a shifting process of said cantilever inclination end portion.

3. A press-contact structure of a probe unit according to claim 1, wherein said supplementary pressure imparting resilient body is formed of a circular columnar body, and one end of said lead and one end of said insulative film are pushed up on a general line of said circular columnar body to form said cantilever inclination end portion.

4. A press-contact structure of a probe unit according to claim 3, wherein said circular columnar body forming said supplementary pressure imparting resilient body is fitted into a V-shaped groove so as to be supported on a pair of inclination surfaces defining said V-shaped groove, and one side portion of said circular columnar body is projected from said V-shaped groove to achieve the push-up action.
